# EUROPEAN PATENT SPECIFICATION

(11) **EP 3 956 411 B1**
(45) Date of publication and mention of the grant of the patent: **10.12.2025**
(21) Application number: 20791425.0
(22) Date of filing: 15.04.2020
(51) Int. Cl.: C09G 1/02, H01L 21/3105, C09C 3/10, B24B 37/24, C09K 3/14, H01L 21/321

(54) **SURFACE COATED ABRASIVE PARTICLES FOR TUNGSTEN BUFF APPLICATIONS**
OBERFLÄCHENBESCHICHTETE SCHLEIFPARTIKEL FÜR WOLFRAMPOLIERANWENDUNGEN
PARTICULES ABRASIVES À REVÊTEMENT DE SURFACE POUR DES APPLICATIONS DE POLISSAGE DE TUNGSTÈNE

(30) Priority: 17.04.2019 US 201962835146 P
(43) Date of publication of application: 23.02.2022
(73) Proprietor: CMC Materials LLC, Wilmington, DE 19801 (US)
(72) Inventor: CHIEN, Chih-Hsien, Aurora, Illinois 60504 (US); LU, Lung-Tai, Aurora, Illinois 60504 (US); HUANG, Hung-Tsung, Aurora, Illinois 60504 (US); HUANG, Helin, Aurora, Illinois 60504 (US)
(74) Representative: Barker Brettell LLP
(86) International application number: PCT/US2020/028255
(87) International publication number: WO 2020/214662

(56) References cited:
- US-A1- 2013 224 955
- US-A1- 2014 051 246
- US-A1- 2015 284 593
- US-A1- 2015 368 515
- US-A1- 2016 108 286
- US-A1- 2019 051 537
- US-A1- 2019 085 205

## Description

### BACKGROUND OF THE INVENTION

Chemical mechanical polishing (CMP) compositions and methods for polishing (or planarizing) the surface of a substrate are well known in the art. Polishing compositions (also known as polishing slurries, CMP slurries, and CMP compositions) for polishing metal layers (such as tungsten) on a semiconductor substrate may include abrasive particles suspended in an aqueous solution and chemical accelerators such as oxidizers, chelating agents, catalysts, and the like.

In a conventional CMP operation, the substrate (wafer) to be polished is mounted on a carrier (polishing head) which is in turn mounted on a carrier assembly and positioned in contact with a polishing pad in a CMP apparatus (polishing tool). The carrier assembly provides a controllable pressure to the substrate, pressing the substrate against the polishing pad. The substrate and pad are moved relative to one another by an external driving force. The relative motion of the substrate and pad abrades and removes a portion of the material from the surface of the substrate, thereby polishing the substrate. The polishing of the substrate by the relative movement of the pad and the substrate may be further aided by the chemical activity of the polishing composition (e.g., by an oxidizing agent and other chemical compounds present in the CMP composition) and/or the mechanical activity of an abrasive suspended in the polishing composition.

In typical tungsten plug and interconnect processes, tungsten is deposited over a dielectric and within openings formed therein. The excess tungsten over the dielectric layer is then removed during a CMP operation to form tungsten plugs and interconnects within the dielectric. Following bulk tungsten removal, the substrate surface can be subjected to a buff polishing step to remove debris and to provide a more uniform topology to the surface. The buff polishing is demanding in that erosion within substrate features such as the tungsten plugs and interconnects, which is excessive metal removal from within the features leading to nonplanarity, must be minimized or more preferably even reversed. The buffing step involves polishing of two or more different materials, such as tungsten, dielectric, and also barrier materials such as silicon nitride, and thus requires a proper balance of the removal rates of the different materials to achieve suitable surface topography. US 2015/368515 A1 discloses chemical-mechanical polishing (CMP) compositions and methods, which are suitable for polishing an aluminum surface. The compositions comprise alumina abrasive particles coated with an anionic polymer, and suspended in an acidic or neutral pH carrier. In some cases, a polishing aid such as silica, a carboxylic acid, a phosphonic acid compound, or a combination thereof may be added to the CMP compositions. The described CMP compositions and methods improve polishing efficacy and reduce surface imperfections on a polished aluminum surface compared to CMP methods using uncoated alumina abrasive. US 2015/284593 A1 discloses stable aqueous polishing compositions that can selectively polish silicon nitride (SiN) films and nearly stop (or polish at very low rates) on silicon oxide films are provided herein. The compositions comprise an anionic abrasive, a nitride removal rate enhancer containing a carboxyl or carboxylate group, water, and optionally, an anionic polymer. The synergistic combination of anionic (negatively charged) abrasives and the nitride removal rate enhancer provide beneficial charge interactions with the dielectric films during CMP, a high SiN rate and selectivity enhancement (over oxide), and stable colloidal dispersed slurries. US 2016/108286 A1 discloses chemical-mechanical polishing composition including (a) an abrasive comprising alumina particles, silica particles, or a combination thereof, (b) a rate accelerator comprising a phosphonic acid, an N-heterocyclic compound, or a combination thereof, (c) a corrosion inhibitor comprising an amphoteric surfactant, a sulfonate, a phosphonate, a carboxylate, a fatty acid amino acid, an amine, an amide, or a combination thereof, (d) an oxidizing agent, and (e) an aqueous carrier. This invention also provides a method of polishing a substrate, especially a substrate comprising a cobalt layer, with the polishing composition.

Conventional polishing compositions containing silica-based abrasives typically result in high roughness, poor topography and edge-over-erosion problems when polishing substrates comprising tungsten. In contrast, polishing compositions comprising treated alumina can provide good topography performance, but typically suffer from unsuitable removal rates. Erosion refers to the excessive removal of tungsten within the substrate features, leading to a non-planar surface topography. In order to minimize or even reduce erosion, a polishing composition must exhibit optimized material removal rates such that the removal of tungsten from the substrate surface features and the removal of silicon oxide and/or SiN is balanced so as to result in optimized surface topography.

Accordingly, there is an ongoing need to develop new polishing methods and compositions for tungsten bulk polishing and buffing applications that provide good surface topography and planarity while minimizing or reversing erosion (e.g., reduced fanging and reduced edge-over-erosion).

### BRIEF SUMMARY OF THE INVENTION

The invention provides a chemical-mechanical polishing composition comprising (a) an abrasive comprising silica particles and alumina particles, wherein the alumina particles are surface-coated with an anionic polymer, and (b) water.

The invention also provides a method of chemically mechanically polishing a substrate comprising (i) providing a substrate, (ii) providing a polishing pad, (iii) providing a chemical-mechanical polishing composition comprising (a) an abrasive comprising silica particles and alumina particles, wherein the alumina particles are surface-coated with an anionic polymer, and (b) water, (iv) contacting the substrate with the polishing pad and the chemical-mechanical polishing composition, and (v) moving the polishing pad and the chemical mechanical polishing composition relative to the substrate to abrade at least a portion of the substrate to polish the substrate.

### DETAILED DESCRIPTION OF THE INVENTION

The invention provides a chemical-mechanical polishing composition comprising, consisting essentially of, or consisting of (a) an abrasive comprising negatively charged colloidal silica particles and alumina particles, wherein the alumina particles are surface-coated with an anionic polymer, wherein the polishing composition has a pH of about 2 to about 5, and (b) water. The abrasive of the inventive chemical-mechanical polishing composition is a mixed particle abrasive such that the abrasive comprises both silica particles and surface-coated alumina particles.

The silica particles of the inventive polishing composition comprise colloidal silica particles, aluminum-doped silica particles, or a combination thereof. Illustrative colloidal silica particles include, for example, PL-3D, PL-2, and PL-5 colloidal silica (primary particle size of about 35 nm, 25 nm, and 60 nm, respectively) commercially available from Fuso Chemical Co. (Tokyo, Japan). Illustrative aluminum-doped silica particles (e.g., aluminate treated) include SNOWTEX^{™}-O silica commercially available from Nissan Chemical (Santa Clara, CA).

In accordance with an aspect of the invention, the alumina particles carry a net negative charge. The negatively-charged alumina particles can be obtained in any suitable manner that provides a negative charge to the alumina particle. Typically, the alumina particles are coated (e.g., surface-coated with an anionic polymer). The alumina particles of the inventive polishing composition can be any suitable alumina particle that is surface-coated with an anionic polymer.

The alumina particles preferably have a surface that comprises (e.g., is coated with) an anionic polymer. The anionic polymer interacts, typically electrostatically, with the alumina particles, which are suspended in the aqueous carrier or fixed on the polishing pad, so as to coat at least a portion of the surface of the abrasive particles. In particular, the anionic polymer associates with alumina particles that have a suitable zeta potential at the pH of the CMP composition. The zeta potential refers to the potential across the interface of solids and liquids, specifically the potential across diffuse layers of ions surrounding charged colloidal particles (e.g., alumina particles). The zeta potential of the alumina particles will vary with pH. For example, an alumina particle with a positive zeta potential can interact electrostatically with the anionic polymer. Also, an alumina particle with a slightly negative zeta potential having sufficient positive sites on the alumina particle surface can interact electrostatically with one or more anionic polymers. The alumina particles preferably have a positive zeta potential at the pH of the CMP composition. The zeta potential of the alumina particles is lowered upon interaction of the anionic polymer with the alumina particles.

Since particles of α-alumina typically have a positively-charged surface in the untreated/uncoated state, the association of the anionic polymer with particles of α-alumina results in deprotonation of at least part of the acidic functional groups on the polymer or copolymer, thus rendering the polymer negatively-charged in association with the alumina particles. The resulting polymer-coated particles have a zeta potential of less than -10 mV over a pH range of 2 to 9.

The alumina particles can be fumed alumina particles or non-fumed α-alumina particles. Fumed alumina particles generally are in the form of aggregates of primary particles, which aggregates are not easily degraded into individual primary particles without significant energy inputs. While the primary particles generally are spherical, the aggregates are chain-like structures of the primary particles and generally are not spherical. Non-fumed α-alumina particles are a crystalline form of alumina and typically do not form aggregates. In a preferred embodiment, the alumina particles are non-fumed α-alumina particles.

The abrasive particles of the inventive polishing compositions can have any suitable average particle size (e.g., average particle diameter). The particle size of a particle is the diameter of the smallest sphere that encompasses the particle. The abrasive particles can have an average particle size of about 10 nm or more, e.g., about 15 nm or more, about 20 nm or more, about 25 nm or more, about 35 nm or more, about 45 nm or more, about 50 nm or more, about 55 nm or more, about 60 nm or more, about 75 nm or more, or about 100) nm or more. Alternatively, or in addition, the abrasive particles can have an average particle size of about 1,000 nm or less, e.g., about 950 nm or less, about 950 nm or less, about 900 nm or less, about 850 nm or less, about 800 nm or less, about 750 nm or less, about 700 nm or less, about 650 nm or less, about 600 nm or less, about 650 nm or less, about 500 nm or less, about 475 nm or less, about 450 nm or less, about 425 nm or less, about 400 nm or less, about 375 nm or less, about 350 nm or less, about 325 nm or less, about 300 nm or less, about 275 nm or less, about 250 nm or less, about 225 nm or less, about 200 nm or less, about 175 nm or less, about 160 nm or less, about 150 nm or less, about 125 nm or less, about 115 nm or less, about 100 nm or less, about 90) nm or less, or about 80 nm or less. For example, abrasive particles can have an average particle size of about 25 nm to about 250 nm. e.g., about 35 nm to about 200 nm, about 45 nm to about 150 nm, about 50 nm to about 125 nm, about 55 nm to about 120 nm, or about 60 nm to about 115 nm. Thus, the abrasive particles can have an average particle size bounded by any two of the aforementioned endpoints. For example, the abrasive particles can have an average particle size of about 10 nm to about 1,000 nm, about 25 nm to about 950 nm, about 30 nm to about 900 nm, about 35 nm to about 850 nm, about 40 nm to about 800 nm, about 45 nm to about 750 nm, about 50 nm to about 700 nm, about 55 nm to about 650 nm, about 60 nm to about 600 nm, about 75 nm to about 550 nm, about 100 nm to about 500 nm, about 25 nm to about 450 nm, about 30 to about 400 nm, about 35 nm to about 350 nm, about 40 nm to about 300 nm, about 45 nm to about 250 nm, or about 50 nm to about 200 nm.

The particle size of the abrasive particles can be measured using any suitable technique, for example, light scattering techniques. Suitable particle size measurement instruments are available from, for example, Malvern Instruments (Malvern, UK).

The fumed alumina particles can have an average particle size of about 30 nm or more, e.g., about 40 nm or more, about 50 nm or more, about 60 nm or more, about 70 nm or more, about 80am or more, about 90 nm. or more, or about 100 nm or more. Alternatively, or in addition, the fumed alumina particles can have an average particle size of about 250 nm or less, e.g., about 230 nm or less, about 210 nm or less, about 190 nm or less, about 170 nm or less, or about 150 nm or less. Thus, the fumed alumina particles can have an average particle size within a range bounded by any two of the aforementioned endpoints. For example, the fumed alumina particles can have an average particle size of about 30 nm to about 250 nm, e.g., about 80 nm to about 250 nm, about 80nm to about 210 nm or about 100 nm to about 150 nm.

The polishing composition can comprise any suitable concentration of abrasive. If the polishing composition of the invention comprises too little abrasive, the composition may not exhibit sufficient removal rate. In contrast, if the polishing composition comprises too much abrasive, the composition may exhibit undesirable polishing performance, may cause surface defects such as scratches, may not be cost effective, and/or may lack stability. The polishing composition can comprise about 10 wt.% or less of abrasive, for example, about 9 wt.% or less, about 8 wt.% or less, about 7 wt.% or less, about 6 wt.% or less, or about 5 wt.% or less. Alternatively, or in addition, the polishing composition can comprise about 0.1 wt.% or more of abrasive, for example, about 0.2 wt.% or more, about 0.3 wt.% or more, about 0.4 wt.% or more, about 0.5 wt.% or more, or about 1 wt.% or more. Thus, the polishing composition can comprise abrasive in an amount bounded by any two of the aforementioned endpoints. For example, the polishing composition can comprise about 0.1 wt.% to about 10 wt.% of abrasive, e.g., about 0.1 wt.% to about 9 wt.% of abrasive, about 0.1 wt.% to about 8 wt.% of abrasive, about 0.1 wt.% to about 7 wt.% of abrasive, about 0.1 wt.% to about 6 wt.% of abrasive, about 0.1 wt.% to about 5 wt.% of abrasive, about 0.1 wt.% to about 5 wt.% of abrasive, about 0.2 wt.% to about 5 wt.% of abrasive, about 0.3 wt.% to about 5 wt.% of abrasive, about 0.4 wt.% to about 5 wt.% of abrasive, about 0.5 wt.% to about 5 wt.% of abrasive, about 0.6 wt.% to about 5 wt.% of abrasive, about 0.7 wt.% to about 5 wt.% of abrasive, about 0.8 wt.% to about 5 wt.% of abrasive, about 0.9 wt.% to about 5 wt.% of abrasive, or about 1 wt.% to about 5 wt.% of abrasive.

In keeping with an aspect of the invention, the alumina particles of the inventive polishing compositions are surface-coated with an anionic polymer. Without wishing to be bound by any particular theory, it is believed that the alumina particle is surface-coated with the anionic polymer via hydrogen bonding and/or via electrostatic interaction between the cationic abrasive particles and the anionic polymer. The anionic polymer can be any suitable anionic polymer.

In an embodiment, the anionic polymer comprises repeating monomeric units selected from carboxylic acid monomeric units, sulfonic acid monomeric units, phosphonic acid monomeric units, and combinations thereof.

In some embodiments, the anionic polymer comprises or consists of repeating units of sulfonic acid. In some embodiments, the anionic polymer comprises or consists of a combination of repeating units of sulfonic acid monomeric units and carboxylic acid monomeric units (i.e., a copolymer). In some embodiments, the anionic polymer comprises or consists of a combination of sulfonic acid monomeric units and phosphonic acid monomeric units (i.e., a copolymer). In some embodiments, the anionic polymer consists of repeating units of sulfonic acid monomeric units. In other embodiments, the anionic polymer is a copolymer of sulfonic acid monomeric units with carboxylic acid units or phosphonic acid monomeric units. The copolymer can be any suitable copolymer comprising or consisting of a combination of sulfonic acid monomeric units and carboxylic acid monomeric units or a combination of sulfonic acid monomeric units and phosphonic acid monomeric units.

Non-limiting examples of suitable sulfonic acid monomeric units include 2-acrylamido-2-methyl-1-propanesulfonic acid (AMPS), 4-vinylbenzenesulfonic acid, vinyl sulfonic acid, 2-sulfoethyl acrylate, 2-sulfoethyl methacrylate, 3-sulfopropyl acrylate, 3-sulfopropyl methacrylate, sodium styrene sulfonate, and 2-propene-1-sulfonic acid, and salts thereof, combinations thereof, and the like.

Non-limiting examples of suitable carboxylic acid monomers include acrylic acid, methacrylic acid, itaconic acid, maleic acid, succinic acid, terephthalic acid, aspartic acid, combinations thereof, and the like.

Non-limiting examples of suitable phosphonic acid monomers include di- or polyphosphonic acids having one or more unsaturated C=C bonds such as vinylidene-1,1-diphosphonic acid), dimethyl-p-vinylbenzylphosphonate, vinylphosphonic acid, ammonium bisdiethylphosphonate (meth)acrylate, acrylamide phosphonate monomers, combinations thereof, and the like.

It is not necessary that the copolymer is produced by copolymerization of a combination of sulfonic acid monomeric units and carboxylic acid monomeric units or a combination of sulfonic acid monomeric units and phosphonic acid monomeric units. It is also contemplated that suitable copolymers can be prepared by post-polymerization processing of precursor copolymers followed by conversion of the copolymers into copolymers having a combination of sulfonic acid monomeric units and carboxylic acid monomeric units or sulfonic acid monomeric units and phosphonic acid monomeric units.

The copolymer can be a random copolymer or a block copolymer. In an embodiment, the copolymer is a random copolymer.

In another embodiment, the anionic polymer comprises a copolymer comprising a combination of sulfonic acid monomeric units and carboxylic acid monomeric units.

In yet another embodiment, the anionic polymer comprises a copolymer comprising a combination of sulfonic acid monomeric units and phosphonic acid monomeric units.

In an embodiment, the anionic polymer comprises repeating monomeric units selected from acrylic acid, methacrylic acid, itaconic acid, maleic acid, succinic acid, terephthalic acid, aspartic acid, maleic anhydride, 4-vinylbenzenesulfonic acid, vinyl sulfonic acid, 2-sulfoethyl acrylate, 2-sulfoethyl methacrylate, 3-sulfopropyl acrylate, 3-sulfopropyl methacrylate, 2-propene-1-sulfonic acid, styrene sulfonic acid, 2-acrylamido-2-methyl-1-propane sulfonic acid, vinylidene-1,1-diphosphonic acid, dimethyl-*p-*vinylbenzylphosphonate, ammonium *bis*diethylphosphonate (meth)acrylate, acrylamide phosphonate monomers, vinylphosphonic acid, 2-(methacroyloxy)ethylphosphate, and combinations thereof.

In a preferred embodiment, the anionic polymer consists of 2-acrylamido-2-methylpropane sulfonic acid monomeric units and acrylic acid monomeric units (AA-AMPS). In accordance with this embodiment, the copolymer may, without limitation, have the 2-acrylamido-2-methylpropane sulfonic acid monomeric units and acrylic acid monomeric units in a molar ratio range of 10: 1 to 1:10.

In another preferred embodiment, the anionic polymer consists of 2-acrylamido-2-methylpropane sulfonic acid monomeric units (AMPS).

The anionic polymer (e.g., copolymer) can have any suitable molecular weight. The anionic polymer can have an average molecular weight of about 500 g/mol or more, for example, about 1,000 g/mol or more, about 2,000 g/mol or more, about 3,000 g/mol or more, about 4,000 g/mol or more, about 5,000 g/mol or more, about 6,000 g/mol or more, about 7,000 g/mol or more, about 8,000 g/mol or more, about 9,000 g/mol or more, about 10,000 g/mol or more, about 15,000 g/mol or more, about 20,000 g/mol or more, about 40,000 g/mol or more, or about 50,000 g/mol or more. Alternatively, or in addition, the anionic polymer can have an average molecular weight of about 100,000 g/mol or less, for example, about 95,000 g/mol or less, about 90,000 g/mol or less, about 85,000 g/mol or less, about 80,000 g/mol or less, about 75,000 g/mol or less, about 70,000 g/mol or less, about 65,000 g/mol or less, about 60,000 g/mol or less, about 55,000 g/mol or less, or about 50,000 g/mol or less. Thus, the anionic polymer can have an average molecular weight bounded by any two of the aforementioned endpoints. For example, the anionic polymer can have an average molecular weight of about 1,000 g/mol to about 100,000 g/mol, about 1,000 g/mol to about 90,000 g/mol, about 1,000 g/mol to about 80,000 g/mol, about 1,000 g/mol to about 70,000 g/mol, about 1,000 g/mol to about 60,000 g/mol, about 1,000 g/mol to about 50,000 g/mol, about 2,000 g/mol to about 50,000 g/mol, about 3,000 g/mol to about 50,000 g/mol, about 4,000 g/mol to about 50,000 g/mol, or about 5,000 g/mol to about 50,000 g/mol.

The alumina particles can be coated with any suitable amount of the anionic polymer. It is also envisioned that the anionic polymer can be added to the polishing composition to coat the alumina particles *in situ.*

The alumina particles can be surface-coated with the anionic polymer (e.g., copolymer) in any suitable manner. In an embodiment, the alumina particles are treated with the copolymer, optionally in the presence of a solvent, prior to addition to the polishing composition. The alumina particles can be surface-coated in water in a separate step to form a dispersion of surface-coated alumina particles, and the resulting dispersion of surface-coated alumina particles used to prepare the polishing composition. In some embodiments, the alumina particles can be surface-coated in the absence of a solvent, or in the presence of a solvent other than the water of the polishing composition or in an additional solvent in combination with the water of the polishing composition. The additional solvent may be removed, for example, by azeotropic distillation to provide a dispersion of the surface-coated alumina particles in water substantially free of the additional solvent. In other embodiments, the surface-coated alumina particles can be isolated as a substantially dry material, i.e., substantially free of any solvent, via filtration, centrifugation, spray drying, or any suitable technique, prior to use in the preparation of the polishing composition. In yet other embodiments, the surface-coated alumina particles are formed *in situ* upon combination of the alumina particles and the anionic polymer (i.e., copolymer) into the polishing composition. In a preferred embodiment, the surface-coated alumina particles are formed by combining the alumina particles and the anionic polymer in an aqueous medium having a pH equal to or less than the isoelectric point of the alumina particles to form an aqueous dispersion of the alumina particles and anionic polymer, and then subjecting the aqueous dispersion of the alumina particles and anionic polymer to conditions so as to thoroughly mix the aqueous dispersion. In an embodiment, the aqueous dispersion is subjected to high shear mixing.

The alumina particles can comprise any suitable amount of the anionic polymer (e.g., copolymer). The amount of anionic polymer refers to the total amount of anionic polymer present in the polishing composition. The alumina particles can comprise about 1 ppm or more of the anionic polymer, for example, about 5 ppm or more, about 10 ppm or more, about 20 ppm or more, about 30 ppm or more, about 40 ppm or more, or about 50 ppm or more. Alternatively, or in addition, the alumina particles can comprise about 500 ppm or less of the anionic polymer, for example, about 450 ppm or less, about 400 ppm or less, about 350 ppm or less, about 300 ppm or less, about 250 ppm or less, about 200 ppm or less, about 150 ppm or less, or about 100 ppm or less. Thus, the alumina particles can comprise the anionic polymer in an amount bounded by any two of the aforementioned endpoints. For example, the alumina particles can comprise about 1 ppm to about 500 ppm of the anionic polymer, e.g., about 5 ppm to about 450 ppm, about 10 ppm to about 400 ppm, about 10 ppm to about 350 ppm, about 10 ppm to about 300 ppm, about 10 ppm to about 250 ppm, about 10 ppm to about 200 ppm, about 10 ppm to about 100 ppm, about 10 ppm to about 90 ppm, about 10 ppm to about 80 ppm, about 10 ppm to about 70 ppm, about 10 ppm to about 60 ppm, about 10 ppm to about 50 ppm, about 10 ppm to about 40 ppm, about 20 ppm to about 300 ppm, about 20 ppm to about 250 ppm, about 20 ppm to about 200 ppm, about 20 ppm to about 150 ppm, or about 20 ppm to about 100 ppm.

In other embodiments, the polishing composition comprises the anionic polymer in an amount based on the weight of the abrasive in the polishing composition. For example, the polishing composition can contain about 0.01 wt.% or more of the anionic polymer, e.g., about 0.05 wt.% or more, about 0.1 wt.% or more, about 0.2 wt.% or more, about 0.3 wt.% or more, about 0.4 wt.% or more, about 0.5 wt.% or more, about 0.6 wt.% or more, about 0.7 wt.% or more, about 0.8 wt.% or more, about 0.9 wt.% or more, or about 1 wt.% or more, based on the weight of the abrasive in the polishing composition. Alternatively, or in addition, the polishing composition can contain about 5 wt.% or less of the anionic polymer, e.g., about 4.5 wt.% or less, about 4 wt.% or less, about 3.5 wt.% or less, about 3 wt.% or less, about 2.5 wt.% or less, or about 2 wt.% or less, based on the weight of the abrasive in the polishing composition. Thus, the polishing composition can comprise the anionic polymer in a weight ratio to abrasive bounded by any two of the aforementioned endpoints. For example, the polishing composition can contain about 0.01 wt.% to about 5 wt.% of the anionic polymer, e.g., about 0.05 wt.% to about 5 wt.%, about 0.1 wt.% to about 5 wt.%, about 0.2 wt.% to about 5 wt.%, about 0.3 wt.% to about 5 wt.%, about 0.4 wt.% to about 5 wt.%, about 0.5 wt.% to about 5 wt.%, about 0.5 wt.% to about 4.5 wt.%, about 0.5 wt.% to about 4 wt.%, about 0.5 wt.% to about 3.5 wt.%, about 0.5 wt.% to about 3 wt.%, about 0.6 wt.% to about 3 wt.%, about 0.7 wt.% to about 3 wt.%, about 0.8 wt.% to about 3 wt.%, about 0.9 wt.% to about 3 wt.%, or about 1 wt.% to about 3 wt.%, based on the weight of the abrasive in the polishing composition.

The abrasive comprising silica particles and surface-coated alumina particles desirably is colloidally stable in the inventive polishing composition. The term colloid refers to the suspension of the abrasive particles in the liquid carrier (e.g., water). Colloidal stability refers to the maintenance of that suspension for a period of time. In the context of this invention, the abrasive is considered colloidally stable if, when the abrasive comprising silica particles and surface-coated alumina particles is placed into a 100 mL graduated cylinder and allowed to stand unagitated for a time of 2 hours, the difference between the concentration of particles in the bottom 50 mL of the graduated cylinder ([B] in terms of g/mL) and the concentration of particles in the top 50 mL of the graduated cylinder ([T] in terms of g/mL) divided by the initial concentration of particles in the abrasive composition ([C] in terms of g/mL) is less than or equal to 0.5 (i.e., {[B] - [T]}/[C] ≤ 0.5). More preferably, the value of [B]-[T]/[C] is less than or equal to 0.3, and most preferably is less than or equal to 0.1.

In some embodiments, the chemical-mechanical polishing composition further comprises an oxidizing agent. Without wishing to be bound to any particular theory, it is believed that the oxidizing agent helps to increase the polishing rate, that is, functions as a rate accelerator. The oxidizing agent can be any suitable oxidizing agent. In certain embodiments, the oxidizing agent comprises ferric ion. The ferric ion can be provided by any suitable source of ferric ion. In some embodiments, the oxidizing agent can comprise a salt of the metal. For example, ferric ion can be provided by a ferric salt comprising inorganic anions such as nitrate ions (e.g., ferric nitrate), cyanide ions (e.g., ferricyanide anion), and the like. The oxidizing agent can also comprise ferric organic iron (III) compounds such as but not limited to acetates, acetylacetonates, citrates, gluconates, oxalates, phthalates, and succinates, and mixtures thereof.

In some embodiments, the oxidizing agent comprises an oxy-containing oxidizing agent. Non-limiting examples of suitable oxy-containing oxidizing agents include persulfate salts, bromate persulfate salts, iodate persulfate salts, perbromate persulfate salts, periodate persulfate salts, peroxides, organic peroxy compounds such as peracetic acid, oxone, and the like.

The chemical-mechanical polishing composition can comprise any suitable amount of the oxidizing agent. The chemical-mechanical polishing composition can comprise about 1 ppm or more of the oxidizing agent, for example, about 5 ppm or more, about 25 ppm or more, about 50 ppm or more, about 75 ppm or more, or about 100 ppm or more. Alternatively, or in addition, the polishing composition can comprise about 2,000 ppm or less of the oxidizing agent, for example, about 1,500 ppm or less, about 1,000 ppm or less, about 500 ppm or less, or about 250 ppm or less. Thus, the polishing composition can comprise an oxidizing agent in an amount bounded by any two of the aforementioned endpoints. For example, the chemical-mechanical polishing composition can comprise about 1 ppm to about 2,000 ppm of oxidizing agent, about 5 ppm to about 1,500 ppm, about 25 ppm to about 1,000 ppm, about 50 ppm to about 500 ppm, or about 75 ppm to about 250 ppm of oxidizing agent.

In some embodiments, the oxidizing agent of the chemical-mechanical polishing composition further comprises hydrogen peroxide. The hydrogen peroxide, when present, can be present in any suitable amount in the polishing composition. For example, the polishing composition can comprise about 0.1 wt.% to about 10 wt.% of hydrogen peroxide, e.g., about 0.5 wt.% to about 10 wt.%, or about 0.5 wt.% to about 5 wt.%.

In some embodiments, the chemical-mechanical polishing composition further comprises a corrosion inhibitor. Without wishing to be bound to any particular theory, the corrosion inhibitor helps to inhibit metal (e.g., tungsten) etching, and thus functions as a corrosion inhibitor. As understood by the skilled artisan, a corrosion inhibitor compound(s) inhibits the conversion of solid metal into soluble metal compounds while at the same time allowing for effective removal of solid metal via the CMP operation. Non-limiting examples of suitable corrosion inhibitors include, for example, glycine, lysine, arginine, alanine, or combinations thereof.

In a preferred embodiment, the chemical-mechanical polishing composition comprises glycine.

Other illustrative corrosion inhibitors include compounds having nitrogen containing functional groups such as nitrogen containing heterocycles, alkyl ammonium ions, amino alkyls, and corrosion inhibitors (i.e., naturally and synthetically occurring), as described herein. In a preferred embodiment, the polishing composition comprises a corrosion inhibitor selected from hexylamine, tetramethyl-p-phenylene diamine, octylamine, diethylene triamine, dibutyl benzylamine, aminopropylsilanol, aminopropylsiloxane, dodecylamine, tyrosine, arginine, glutamine, glutamic acid, cystine, lysine, glycine (aminoacetic acid), and combinations thereof.

The polishing composition can comprise any suitable amount of a corrosion inhibitor. If the composition comprises too little of a corrosion inhibitor, the composition may not exhibit sufficient polishing performance. In contrast, if the polishing composition comprises too much of a corrosion inhibitor, the composition may not be cost effective and/or may lack stability. Accordingly, the polishing composition can comprise about 10 wt.% or less of a corrosion inhibitor, for example, about 9 wt.% or less, about 8 wt.% or less, about 7 wt.% or less, about 6 wt.% or less, about 5 wt.% or less, about 4 wt.% or less, about 3 wt.% or less, or about 2 wt.% or less. Alternatively, or in addition, the polishing composition can comprise about 0.01 wt.% or more of a corrosion inhibitor, for example, about 0.05 wt.% or more, about 0.1 wt.% or more, about 0.5 wt.% or more, about 1 wt.% or more, or about 1.5 wt.% or more. Thus, the polishing composition can comprise a corrosion inhibitor in an amount bounded by any two of the aforementioned endpoints. For example, the polishing composition can comprise a corrosion inhibitor in an amount of about 0.01 wt.% to about 10 wt.%, e.g., about 0.05 wt.% to about 9 wt.%, about 0.1 wt. % to about 8 wt.%, about 0.5 wt.% to about 7 wt.%, about 1 wt.% to about 6 wt.%, about 1.5 wt.% to about 5 wt.%, or about 2 wt.% to about 4 wt.%.

In an embodiment, the polishing composition comprises a corrosion inhibitor in an amount of about 0.02 wt.% to about 0.2 wt.%, for example, about 0.05 wt.%, about 0.1 wt.%, or about 0.15 wt.%.

In some embodiments, the chemical-mechanical polishing composition further comprises a stabilizer. Typically, the stabilizer comprises an organic carboxylic acid. The stabilizer helps to stabilize the ferric ion of the oxidizing agent, when present. Without wishing to be bound to any particular theory, it is believed that the stabilizer (e.g., organic carboxylic acid) helps to prevent the ferric ion from degrading other components in the composition over time, that is, attenuates the reactivity of the ferric ion. Moreover, it is believed that the addition of a stabilizer reduces the effectiveness of the ferric ion containing oxidizing agent such that the choice of the type and amount of stabilizer added to the polishing composition may have a significant impact on CMP performance. Without wishing to be bound to any particular theory, it is believed that the addition of a stabilizer may lead to the formation of a stabilizer/oxidizing agent complex that inhibits the reactivity of the oxidizing agent while at the same time allowing the oxidizing agent to remain sufficiently active so as to promote rapid tungsten polishing rates.

Preferred stabilizers include organic carboxylic acids such as, for example, acetic acid, phthalic acid, citric acid, adipic acid, oxalic acid, malonic acid, aspartic acid, succinic acid, glutaric acid, pimelic acid, suberic acid, azelaic acid, sebacic acid, maleic acid, glutaconic acid, muconic acid, ethylenediaminetetraacetic acid (EDTA), propylenediaminetetraacetic acid (PDTA), and mixtures thereof. In an embodiment, the stabilizer is malonic acid. The stabilizers may be used in their conjugate form, e.g., the carboxylate can be used instead of the carboxylic acid. The term "acid" also includes the conjugate base (or bases) of the acid. For example, the term "adipic acid" includes adipic acid and its conjugate bases. Organic carboxylic acids can be used alone or in combination and significantly decrease the rate at which oxidizers such as hydrogen peroxide decomposes.

The polishing composition can comprise any suitable amount of a stabilizer. If the composition comprises too little stabilizer, the composition may not exhibit sufficient polishing performance or be unstable. In contrast, if the polishing composition comprises too much of organic carboxylic acid, the composition may not be cost effective and/or may lack stability. Accordingly, the polishing composition can comprise about 10 wt.% or less of a stabilizer, for example, about 9 wt.% or less, about 8 wt.% or less, about 7 wt.% or less, about 6 wt.% or less, about 5 wt.% or less, about 4 wt.% or less, about 3 wt.% or less, or about 2 wt.% or less. Alternatively, or in addition, the polishing composition can comprise about 0.01 wt.% or more of a stabilizer, for example, about 0.05 wt.% or more, about 0.1 wt.% or more, about 0.5 wt.% or more, about 1 wt.% or more, or about 1.5 wt.% or more. Thus, the polishing composition can comprise a stabilizer in an amount bounded by any two of the aforementioned endpoints. For example, the polishing composition can comprise a stabilizer in an amount of about 0.001 wt.% to about 10 wt.%, e.g., about 0.005 wt.% to about 9 wt.%, about 0.01 wt. % to about 8 wt.%, about 0.05 wt.% to about 7 wt.%, about 0.1 wt.% to about 6 wt.%, about 0.5 wt.% to about 5 wt.%, about 1 wt.% to about 4 wt.%, or about 1.5 wt.% to about 3 wt.%.

In an embodiment, the polishing composition comprises a stabilizer in an amount of about 0.01 wt.% to about 1 wt.% (e.g., about 0.05 wt.%). In another embodiment, the polishing composition comprises a stabilizer in an amount of about 0.1 wt.%.

In some embodiments, the chemical-mechanical polishing composition further comprises an organic phosphonic acid. Without wishing to be bound to any particular theory, it is believed that the organic phosphonic acid increases the polishing rate of silicon oxide thereby functioning as an oxide removal rate promoter. The inclusion of the organic phosphonic acid is believed to improve the removal rate and decrease imperfections on the polished oxide surface. The organic phosphonic acid, when present, can be any suitable organic phosphonic acid. Non-limiting examples of suitable organic phosphonic acids include 2-aminoethylphosphonic acid, 1-hydroxyethylidene-1,1-diphosphonic acid, aminotri(methylenephosphonic acid), ethylenediaminetetra(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, α-methyl phosphonosuccinic acid, and combinations thereof.

The polishing composition can comprise any suitable amount of the organic phosphonic acid. The polishing composition can comprise about 0.01 wt.% or more of the organic phosphonic acid, for example, about 0.02 wt.% or more, about 0.03 wt.% or more, about 0.04 wt.% or more, about 0.05 wt.% or more, about 0.06 wt.% or more, about 0.07 wt.% or more, about 0.08 wt.% or more, about 0.09 wt.% or more, or about 0.1 wt.% or more of the organic phosphonic acid. Alternatively, or in addition, the polishing composition can comprise about 2 wt.% or less, for example, about 1.9 wt.% or less, about 1.8 wt.% or less, about 1.7 wt.% or less, about 1.6 wt.% or less, about 1.5 wt.% or less, about 1.4 wt.% or less, about 1.3 wt.% or less, about 1.2 wt.% or less, about 1.1 wt.% or less, or about 1 wt.% or less of the organic phosphonic acid. Thus, the polishing composition can comprise the organic phosphonic acid in an amount bounded by any two of the aforementioned endpoints. For example, the polishing composition can contain about 0.01 wt.% to about 2 wt.% of the organic phosphonic acid, about 0.01 wt.% to about 1 wt.%, about 0.02 wt.% to about 1 wt.%, about 0.03 wt.% to about 1 wt.%, about 0.04 wt.% to about 1 wt.%, about 0.05 wt.% to about 0.5 wt.%, or about 0.1 wt.% to about 0.5 wt.%.

The polishing composition desirably has a pH of about 2 to about 5. Thus, the polishing composition can have a pH of about 2 or more, e.g., about 2.1 or more, about 2.2 or more, about 2.3 or more, about 2.4 or more, about 2.5 or more, about 2.6 or more, about 2.7 or more, about 2.8 or more, about 2.9 or more, about 3.0 or more, about 3.1 or more, about 3.2 or more, about 3.3 or more, or about 3.4 or more. Alternatively, or in addition, the polishing composition can have a pH of about 5 or less, e.g., about 4.9 or less, about 4.8 or less, about 4.7 or less, about 4.6 or less, about 4.5 or less, about 4.4 or less, about 4.3 or less, about 4.2 or less, about 4.1 or less, about 4 or less, about 3.9 or less, about 3.8 or less, about 3.7 or less, about 3.6 or less, or about 3.5 or less. Thus, the polishing composition can have a pH bounded by any two of the aforementioned endpoints. For example, the polishing composition can have a pH of about 2 to about 5, e.g., about 2.1 to about 5, about 2.2 to about 4.9, about 2.3 to about 4.8, about 2.4 to about 4.7, about 2.5 to about 4.6, about 2.6 to about 4.5, about 2.7 to about 4.4, about 2.8 to about 4.3, about 2.9 to about 4.2, about 3.0 to about 4.1, about 3.1 to about 4.0, about 3.0 to about 3.5, or about 3.2 to about 3.9.

The pH of the polishing composition can be adjusted as necessary using any suitable acid or base. Non-limiting examples of suitable acids include nitric acid, sulfuric acid, phosphoric acid, and organic acids such as formic acid and acetic acid. Non-limiting examples of suitable bases include sodium hydroxide, potassium hydroxide, and ammonium hydroxide.

The polishing composition optionally further comprises one or more additives. Illustrative additives include a biocide, a buffer, a surfactant, a catalyst, and combinations thereof. It is desirable that the additives, when present, are not detrimental to the stability of the polishing composition.

A biocide, when present, can be any suitable biocide and can be present in the polishing composition in any suitable amount. A suitable biocide is an isothiazolinone biocide. The amount of biocide in the polishing composition typically is about 1 ppm to about 500 ppm, preferably about 10 ppm to about 125 ppm. An illustrative biocide is KATHON^{™} commercially available from Dow Chemical (Midland, MI).

The polishing composition can be prepared by any suitable technique, many of which are known to those skilled in the art. The polishing composition can be prepared in a batch or continuous process. Generally, the polishing composition can be prepared by combining the components thereof in any order. The term "component" as used herein includes individual ingredients (e.g., silica particles, alumina particles surface-coated with an anionic polymer, optional oxidizing agent, optional hydrogen peroxide, optional organic phosphonic acid, optional corrosion inhibitor, optional buffering agent, optional pH adjustor, etc.) as well as any combination of ingredients (e.g., silica particles, alumina particles surface-coated with an anionic polymer, optional oxidizing agent, optional hydrogen peroxide, optional organic phosphonic acid, optional corrosion inhibitor, optional buffering agent, optional pH adjustor, etc.).

For example, the silica particles and alumina particles surface-coated with an anionic polymer can be dispersed in water. The optional oxidizing agent, optional hydrogen peroxide, optional organic phosphonic acid, optional corrosion inhibitor, optional buffering agent, and optional pH adjustor can then be added and mixed by any method that is capable of incorporating the components into the polishing composition. The optional oxidizing agent and/or optional hydrogen peroxide can be added at any time during the preparation of the polishing composition. Alternatively, the alumina particles can be surface-coated with the anionic polymer separately, and the silica particles and the surface-coated alumina either provided in water or dispersed in water, followed by addition of the optional oxidizing agent, optional hydrogen peroxide, optional organic phosphonic acid, optional corrosion inhibitor, optional buffering agent, and optional pH adjustor and mixing by any method that is capable of incorporating the components into the polishing composition. The polishing composition can be prepared prior to use, with one or more components, such as the optional oxidizing agent and/or optional hydrogen peroxide, added to the polishing composition just before use (e.g., within about 1 minute before use, or within about 1 hour before use, or within about 7 days before use). The polishing composition also can be prepared by mixing the components at the surface of the substrate during the polishing operation.

The polishing composition can be supplied as a one-package system comprising silica particles and alumina particles surface-coated with an anionic polymer, optional oxidizing agent, optional hydrogen peroxide, optional organic phosphonic acid, optional corrosion inhibitor, optional buffering agent, and optional pH adjustor and water. In another embodiment, the polishing composition can be supplied as a one-package system comprising the abrasive, anionic polymer, oxidizing agent, optional hydrogen peroxide, optional organic phosphonic acid, optional corrosion inhibitor, optional buffering agent, and optional pH adjustor and water. Alternatively, the abrasive comprising silica particles and alumina particles surface-coated with an anionic polymer can be supplied as a dispersion in water in a first container, and the oxidizing agent, optional hydrogen peroxide, optional organic phosphonic acid, optional corrosion inhibitor, optional buffering agent, and optional pH adjustor and water can be supplied in a second container, either in dry form, or as a solution or dispersion in water. In an alternative embodiment, the abrasive can be supplied as a dispersion in water in a first container, and the anionic polymer, oxidizing agent, optional hydrogen peroxide, optional organic phosphonic acid, optional corrosion inhibitor, optional buffering agent, and optional pH adjustor and water can be supplied in a second container, either in dry form, or as a solution or dispersion in water. The oxidizing agent and/or optional hydrogen peroxide desirably is supplied separately from the other components of the polishing composition and is combined, e.g., by the end-user, with the other components of the polishing composition shortly before use (e.g., 1 week or less prior to use, 1 day or less prior to use, 1 hour or less prior to use, 10 minutes or less prior to use, or 1 minute or less prior to use). The components in the first or second container can be in dry form while the components in the other container can be in the form of an aqueous dispersion. Moreover, it is suitable for the components in the first and second containers to have different pH values, or alternatively to have substantially similar, or even equal, pH values. Other two-container, or three or more-container, combinations of the components of the polishing composition are within the knowledge of one of ordinary skill in the art.

The polishing composition of the invention also can be provided as a concentrate which is intended to be diluted with an appropriate amount of water prior to use. In such an embodiment, the polishing composition concentrate can comprise the abrasive comprising silica particles and alumina particles surface-coated with an anionic polymer, optional organic phosphonic acid, optional corrosion inhibitor, optional buffering agent, and optional pH adjustor and water, with or without the oxidizing agent and/or optional hydrogen peroxide, in amounts such that, upon dilution of the concentrate with an appropriate amount of water, and the hydrogen peroxide if not already present in an appropriate amount, each component of the polishing composition will be present in the polishing composition in an amount within the appropriate range recited above for each component. In another embodiment, the polishing composition concentrate can comprise the abrasive, anionic polymer, optional organic phosphonic acid, optional corrosion inhibitor, optional buffering agent, and optional pH adjustor and water, with or without the oxidizing agent and/or optional hydrogen peroxide, in amounts such that, upon dilution of the concentrate with an appropriate amount of water, and the hydrogen peroxide if not already present in an appropriate amount, each component of the polishing composition will be present in the polishing composition in an amount within the appropriate range recited above for each component. For example, the abrasive, anionic polymer, oxidizing agent, optional organic phosphonic acid, optional corrosion inhibitor, optional buffering agent, and optional pH adjustor or the abrasive comprising silica particles and alumina particles surface-coated with an anionic polymer, oxidizing agent, optional hydrogen peroxide, optional organic phosphonic acid, optional corrosion inhibitor, optional buffering agent, and optional pH adjustor can each be present in the concentration in an amount that is about 2 times (e.g., about 3 times, about 4 times, or about 5 times) greater than the concentration recited above for each component so that, when the concentrate is diluted with an equal volume of water (e.g., 2 equal volumes of water, 3 equal volumes of water, or 4 equal volumes of water, respectively), along with the optional hydrogen peroxide in a suitable amount, each component will be present in the polishing composition in an amount within the ranges set forth above for each component. Furthermore, as will be understood by those of ordinary skill in the art, the concentrate can contain an appropriate fraction of the water present in the final polishing composition in order to ensure that other components are at least partially or fully dissolved in the concentrate.

The invention also provides a method of chemically mechanically polishing a substrate comprising (i) providing a substrate, (ii) providing a polishing pad, (iii) providing a chemical-mechanical polishing composition comprising (a) an abrasive comprising negatively charged colloidal silica particles and alumina particles, wherein the alumina particles are surface-coated with an anionic polymer, wherein the polishing composition has a pH pf about 2 to about 5, and (b) water, (iv) contacting the substrate with the polishing pad and the chemical-mechanical polishing composition, and (v) moving the polishing pad and the chemical mechanical polishing composition relative to the substrate to abrade at least a portion of the substrate to polish the substrate. The chemical-mechanical polishing composition can be used to polish any suitable substrate and is especially useful for polishing substrates comprising at least one layer (typically a surface layer) comprised of tungsten and at least one layer of silicon oxide and silicon nitride. Preferably, the substrate comprises at least one layer of tungsten on a surface of the substrate, at least one layer of silicon oxide on a surface of the substrate, and at least one layer of silicon nitride on a surface of the substrate, wherein at least a portion of the tungsten, silicon oxide, and/or silicon nitride on a surface of the substrate is abraded to thereby polish the substrate.

The chemical-mechanical polishing composition is particularly suited for use in both a bulk polishing step and a post-polishing buffing step of substrates comprising tungsten, silicon oxide, and silicon nitride. Applicants have surprisingly found that the inventive polishing composition comprising mixed particles advantageously provides suitable substrate removal rates and substrate selectivities in both bulk polishing and buff polishing applications heretofore unobserved with a single polishing composition. In conventional polishing systems, more than one polishing composition typically is required to achieve suitable removal rates, selectivities, and topography performance. The inventive polishing compositions exhibit removal rates for tungsten and silicon oxide and/or SiN such that erosion is minimized in both a bulk tungsten polishing step and a buffing step. For example, removal rates for tungsten are lower than the removal rates for silicon oxide or silicon nitride when using the inventive polishing composition. Tungsten to silicon oxide removal rates are 1:2 or higher (e.g. W:TEOS of 1:2.5 or higher, 1:5 or higher, 1: 10 or higher). Similarly, Tungsten to silicon nitride removal rates are 1:2 or higher (e.g. W:SiN of 1:2.5 or higher, 1:5 or higher, 1: 10 or higher).

In an embodiment, the substrate comprises a silicon oxide layer on a surface of the substrate and/or a nitride layer (e.g., silicon nitride or titanium nitride) on a surface of the substrate, wherein at least a portion of the silicon oxide layer and/or at least a portion of the nitride layer are abraded to polish the substrate.

The silicon oxide can be any suitable silicon oxide, many forms of which are known in the art. Suitable types of silicon oxide include, but are not limited to, tetraethylorthosilicate (TEOS), borophosphosilicate glass (BPSG), plasma enhanced TEOS (PETEOS), thermal oxide, undoped silicate glass, and HDP oxide.

In an embodiment, the silicon oxide is tetraethylorthosilica (TEOS).

In an embodiment, the nitride is silicon nitride (SiN).

In certain embodiments, the substrate is prepared by forming surface features on substrates comprising, for example, a layer of silicon oxide on the surface of a silicon wafer. Subsequently, the substrate surface is coated with a layer of circuit-forming material such as tungsten, leaving an overburden of tungsten filling the surface features. Initial polishing of the tungsten overburden exposes the surface silicon oxide, thereby forming substrate circuit features comprising tungsten and/or cobalt filled lines separated by regions of silicon oxide, after which a buffing step can be performed to reduce surface defects resulting from the initial polishing step and to remove or reduce scratches and residue on the substrate surface.

In an embodiment, the substrate comprises a tungsten layer on a surface of the substrate, wherein at least a portion of the tungsten layer is abraded to polish the substrate.

In an embodiment, the substrate further comprises a tungsten layer on a surface of the substrate, wherein at least a portion of the tungsten layer in addition to at least a portion of the oxide and/or nitride layer, to polish the substrate.

The chemical-mechanical polishing composition and method of the invention are particularly suited for use in conjunction with a chemical-mechanical polishing apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving the substrate relative to the surface of the polishing pad. The polishing of the substrate takes place by the substrate being placed in contact with the polishing pad and the polishing composition of the invention, and then the polishing pad moving relative to the substrate, so as to abrade at least a portion of a surface of the substrate to polish the substrate.

A substrate can be polished with the chemical-mechanical polishing composition using any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof. Soft polyurethane polishing pads are particularly useful in conjunction with the inventive polishing method. Typical pads include but are not limited to SURFIN^{™} 000, SURFIN^{™} SSW1, SPM3100 (commercially available from, for example, Eminess Technologies), POLITEX^{™}, Fujibo POLYPAS^{™} 27 and NexPlanar ^{®} E6088 Series pad (commercially available from Cabot Microelectronics).
Desirably, the chemical-mechanical polishing apparatus further comprises an *in situ* polishing endpoint detection system, many of which are known in the art. Techniques for inspecting and monitoring the polishing process by analyzing light or other radiation reflected from a surface of the substrate being polished are known in the art. Such methods are described, for example, in U.S. Patent 5,196,353, U.S. Patent 5,433,651, U.S. Patent 5,609,511, U.S. Patent 5,643,046, U.S. Patent 5,658,183, U.S. Patent 5,730,642, U.S. Patent 5,838,447, U.S. Patent 5,872,633, U.S. Patent 5,893,796, U.S. Patent 5,949,927, and U.S. Patent 5,964,643. Desirably, the inspection or monitoring of the progress of the polishing process with respect to a substrate being polished enables the determination of the polishing end-point, i.e., the determination of when to terminate the polishing process with respect to a particular substrate.EXAMPLES

Polishing compositions contained one or more of the eleven abrasive particles described in Table 1 (Particles Nos. 1-11). The abrasive particles, prior to any surface-coating, were obtained from commercial sources, for example, Fuso Chemical Co. (Tokyo, Japan); Nissan Chemical Corp. (Santa Clara, CA); and Cabot Microelectronics Corp. (Aurora, IL).

The following abbreviations are used herein: AMPS refers to 2-acrylamido-2-methyl-1-propanesulfonic acid; AA-AMPS refers to acrylic acid-2-acrylamido-2-methyl-1-propanesulfonic acid; W refers to tungsten; TEOS refers to tetraethylorthosilicate; SiN refers to silicon nitride; CON refers to a control polishing composition; and RR refers to removal rate.

**Table 1: Abrasive Particles**

| **Abrasive Particle No.** | **Particle Description (average particle size)** |
|---|---|
| 1 | (AA-AMPS) copolymer coated α-alumina (90 nm) |
| 2 | (AA-AMPS) copolymer coated α-alumina (130 nm) |
| 3 | (AMPS) polymer coated α-alumina (130 nm) |
| 4 | Colloidal silica (50 nm) |
| 5 | Colloidal silica (100 nm) |
| 6 | Colloidal silica (120 nm) |
| 7 | Sulfonate modified colloidal silica (70 nm) |
| 8 | Amino modified colloidal silica (100 nm) |
| 9 | Aluminum-doped colloidal silica (20 nm) |
| 10 | Sulfonate modified colloidal silica (120 nm) |
| 11 | Fumed silica (160 nm) |

Unless otherwise noted, all polishing compositions contained the following components in addition to those described in the Examples: 0.1 wt.% glycine as a corrosion inhibitor, 0.03 wt.% ferric nitrate as an oxidizing agent, 0.0608 wt.% malonic acid as a stabilizer, 15 ppm KATHON^{™} biocide, and 0.5 wt.% DEQUEST^{™} 2010 containing 1-hydroxyethylidene-1,1-diphosphonic acid (i.e., an organic phosphonic acid) as a silicon oxide removal rate promoter. The pH of the polishing compositions was adjusted using nitric acid or potassium hydroxide as necessary.

The control polishing composition ("CON") for the experiments in Examples 1-4 had a pH of 3 and contained 0.5 wt.% of (AA-AMPS) copolymer coated α-alumina having an average particle size of 90 nm (Particle No. 1) as the only abrasive particle.

In the polishing experiments described in Examples 1-4, substrates comprising tungsten, TEOS, and SiN were polished using the following parameters: MIRRA^{™} polisher (Applied Materials, Santa Clara, CA), Fujibo H7000 pad (Tokyo, Japan), 1.5 psi of downforce, and a flow rate of 150 mL/min.

### EXAMPLE 1

This example demonstrates the effect of pH on tungsten, TEOS, and SiN removal rates for polishing compositions in accordance with the invention.

Substrates were polished with four polishing compositions (i.e., inventive Polishing Compositions 1A-1C and CON). Each of Polishing Compositions 1A-1C contained 0.5 wt.% of colloidal silica having an average particle size of 120 nm (Particle No. 6) and 0.5 wt.% of (AA-AMPS) copolymer coated α-alumina having an average particle size of 90 nm (Particle No. 1).

The pH of the polishing compositions and the polishing results are set forth in Table 2.

**TABLE 2: Removal Rate as a Function of Polishing Composition pH**

| **Polishing Composition** | **SiO₂ Particle (wt.%)** | **Al₂O₃ Particle (wt.%)** | **pH** | **W RR (Å/min)** | **TEOS RR (Å/min)** | **SiN RR (Å/min)** |
|---|---|---|---|---|---|---|
| CON | -- | 1 (0.5) | 3 | 86 | 116 | 113 |
| 1A | 6 (0.5) | 1 (0.5) | 2 | 83 | 181 | 157 |
| 1B | 6(0.5) | 1 (0.5) | 3 | 76 | 184 | 147 |
| 1C | 6 (0.5) | 1 (0.5) | 4 | 67 | 171 | 134 |

As is apparent from the results set forth in Table 2, inventive Polishing Compositions 1A-1C each exhibited suitable W, TEOS, and SiN removal rates and suitable TEOS:W and SiN:W selectivities over a pH range of 2 to 4. In addition, inventive Polishing Compositions 1A-1C comprising silica particles and alumina particles surface-coated with an anionic polymer exhibited improved TEOS and SiN selectivities compared to a polishing composition comprising only a surface-coated alumina particle as the abrasive (CON).

### EXAMPLE 2

This example demonstrates the effect of colloidal silica particle size and concentration on tungsten, TEOS, and SiN removal rates for polishing compositions according to the invention.

Substrates were polished with five polishing compositions (i.e., inventive Polishing Compositions 2A-2D and CON). Each of Polishing Compositions 2A-2D and CON had a pH of 3 and contained 0.5 wt.% of (AA-AMPS) copolymer coated α-alumina having an average particle size of 90 nm (Particle No. 1).

Polishing Composition 2A contained 0.5 wt.% of colloidal silica having a primary particle size of 100 nm (Particle No. 5). Polishing Composition 2B contained 1 wt.% of colloidal silica having an average particle size of 100 nm (Particle No. 5). Polishing Composition 2C contained 0.5 wt.% of colloidal silica having an average particle size of 50 nm (Particle No. 4). Polishing Composition 2D contained 1 wt.% of colloidal silica having an average particle size of 50 nm (Particle No 4).

The substrate polishing results are set forth in Table 3.

**TABLE 3: Removal Rate as a Function of Silica Particle Size and Concentration**

| **Polishing Composition** | **SiO₂ Particle (wt.%)** | **Al₂O₃ Particle (wt.%)** | **W RR (Å/min)** | **TEOS RR (Å/min)** | **SiN RR (Å/min)** |
|---|---|---|---|---|---|
| CON | -- | 1 (0.5) | 86 | 116 | 113 |
| 2A | 5 (0.5) | 1 (0.5) | 80 | 156 | 139 |
| 2B | 5 (1) | 1 (0.5) | 81 | 227 | 164 |
| 2C | 4 (0.5) | 1 (0.5) | 85 | 155 | 156 |
| 2D | 4 (1) | 1 (0.5) | 84 | 201 | 188 |

As is apparent from the results set forth in Table 3, inventive Polishing Compositions 2A-2D exhibited suitable W, TEOS, and SiN removal rates and suitable TEOS:W and SiN:W selectivities. Each of the inventive polishing compositions containing a mixed abrasive exhibited improved performance compared to control. In addition, Polishing Compositions 2B and 2D, which contained 1 wt.% silica, exhibited higher TEOS and SiN removal rates when compared to Polishing Compositions 2A and 2C, which contained 0.5 wt.% silica. Thus, these results show the beneficial impact of silica particles on polishing compositions according to the invention.

### EXAMPLE 3

This example demonstrates the effect of silica particle charge on tungsten, TEOS, and SiN removal rates for polishing compositions in accordance with the invention.

Substrates were polished with eleven polishing compositions (i.e., Polishing Compositions 3A-3J and CON). Each of Polishing Compositions 3A-3J had a pH of 3 and each contained 0.5 wt.% of (AA-AMPS) copolymer coated α-alumina having an average particle size of 90 nm (Particle No. 1). Each composition also contained the particles described in Table 4, below.

More specifically, Polishing Compositions 3A and 3B contained 0.5 wt.% and 1 wt. %, respectively, of sulfonate modified colloidal silica having an average particle size of 70 nm (Particle No. 7). Polishing Compositions 3C and 3D contained 0.5 wt.% and 1 wt.%, respectively, of sulfonate modified colloidal silica having an average particle size of 120 nm (Particle No. 10). Polishing Compositions 3E and 3F contained 0.5 wt.% and 1 wt.%, respectively, of amino modified colloidal silica having an average particle size of 100 nm (Particle No. 8). Polishing Compositions 3G and 3H contained 0.5 wt.% and 1 wt.%, respectively, of fumed silica having an average particle size of 160 nm (Particle No. 11). Polishing Compositions 3I and 3J contained 0.5 wt.% and 1 wt.%, respectively, of aluminum-doped colloidal silica having an average particle size of 20 nm (Particle No. 9).

The polishing results are set forth in Table 4.

**TABLE 4: Removal Rate as a Function of Silica Particle Charge**

| **Polishing Composition** | **Al₂O₃ Particle (wt.%)** | **SiO₂ Particle (wt.%)** | **SiO₂ Particle Charge** | **W RR (Å/min)** | **TEOS RR (Å/min)** | **SiN RR (Å/min)** |
|---|---|---|---|---|---|---|
| CON | 1 (0.5) | -- | -- | 86 | 116 | 113 |
| 3A | 1 (0.5) | 7 (0.5) | (-) | 94 | 120 | 114 |
| 3B | 1 (0.5) | 7 (1) | (-) | 107 | 153 | 129 |
| 3C | 1 (0.5) | 10 (0.5) | (-) | 85 | 162 | 155 |
| 3D | 1 (0.5) | 10 (1) | (-) | 83 | 177 | 152 |
| 3E | 1 (0.5) | 8 (0.5) | (+) | -- | -- | -- |
| 3F | 1 (0.5) | 8 (1) | (+) | -- | -- | -- |
| 3G | 1 (0.5) | 11 (0.5) | (-) fumed | 69 | 61 | 66 |
| 3H | 1 (0.5) | 11 (1) | (-) fumed | 78 | 80 | 70 |
| 3I | 1 (0.5) | 9 (0.5) | (-) | 94 | 131 | 124 |
| 3J | 1 (0.5) | 9 (1) | (-) | 94 | 151 | 136 |

As is apparent from the results set forth in Table 4, polishing compositions containing negatively charged colloidal silica particles (i.e., Polishing Compositions 3A-3D, 3I, and 3J) exhibited suitable W, TEOS, and SiN removal rates, as well as TEOS:W and SiN:W selectivities. Polishing Compositions 3A-3D, 3I, and 3J exhibited improved polishing performance compared to control.

The polishing compositions containing positively charged silica particles (Polishing Compositions 3E and 3F), and including negatively charged fumed silica in particular (Polishing Composition 3G and 3H), did not exhibit suitable polishing performance. Polishing Compositions 3E and 3F containing amino modified silica particles were not stable. Polishing Compositions 3G and 3H containing fumed silica as the only silica particle did not exhibit either increased TEOS:W selectivity, or increased SiN:W selectivity.

### EXAMPLE 4

This example demonstrates the effect of varying amounts of silica particles and surface-coated alumina particles on the tungsten, TEOS, and SiN removal rates for polishing compositions in accordance with the invention.

Substrates were polished with seven polishing compositions (i.e., inventive Polishing Compositions 4A-4F and CON). Each of Polishing Compositions 4A-4F had a pH of 3 and contained varying amounts of colloidal silica particles having an average particle size of 120 nm (Particle No. 6) as shown in Table 5.

Polishing Composition 4A contained 0.5 wt.% of (AA-AMPS) copolymer coated α-alumina having an average particle size of 130 nm (Particle No. 2). Polishing Composition 4B contained 0.5 wt.% (AMPS) polymer coated α-alumina having an average particle size of 130 nm (Particle No. 3). Polishing Compositions 4C-4F contained varying amounts of (AA-AMPS) copolymer coated α-alumina having an average particle size of 90nm (Particle No. 1) as shown in Table 5.

The polishing results are set forth in Table 5.

**TABLE 5: Removal Rate as a Function of Abrasive Concentration**

| **Polishing Composition** | **SiO₂ Particle (wt.%)** | **Al₂O₃ Particle (wt.%)** | **W RR (Å/min)** | **TEOS RR (Å/min)** | **SiN RR (Å/min)** |
|---|---|---|---|---|---|
| CON | -- | 1 (0.5) | 86 | 116 | 113 |
| 4A | 6 (0.5) | 2 (0.5) | 72 | 171 | 147 |
| 4B | 6 (0.5) | 3 (0.5) | 87 | 203 | 157 |
| 4C | 6 (0.5) | 1 (0.2) | 75 | 134 | 112 |
| 4D | 6 (0.5) | 1 (0.5) | 76 | 184 | 147 |
| 4E | 6 (1) | 1 (0.2) | 74 | 191 | 124 |
| 4F | 6 (1) | 1 (0.5) | 78 | 221 | 155 |

As is apparent from the results set forth in Table 5, inventive Polishing Compositions 4A-4F exhibited suitable W, TEOS, and SiN removal rates and suitable TEOS:W and SiN:W selectivities. Each of the inventive polishing compositions containing a mixed abrasive exhibited improved performance compared to control.

### EXAMPLE 5

This example demonstrates the effect of varying amounts of silica particles and surface-coated alumina particles on topography performance for polishing compositions in accordance with the invention.

Substrates comprising TEOS (100 Å features) were separately polished with eight polishing compositions (i.e., Polishing Compositions 5A-5J) with a soft pad (Fujibo H600) and a medium hard pad (U5050, manufactured by Cabot Microelectronics Corp.)) on a MIRRA^{™} polisher using a downforce of 1.5 psi and a post CMP clean either ammonium hydroxide (soft pad experiments) or ammonium hydroxide diluted with hydrofluoric acid (medium hard pad experiments). Each of Polishing Compositions 5A-5H had a pH of 3 and included the abrasive particles identified in Table 6.

Polishing Compositions 5A, 5G, and 5H were control compositions. Polishing Composition 5A contained only 0.5 wt.% of (AA-AMPS) copolymer coated α-alumina having an average particle size of 90 nm (Particle No. 1). Polishing Composition 5G contained only 1 wt.% of colloidal silica having an average particle size of 120 nm (Particle No. 6). Polishing Composition 5H contained only 1 wt.% of colloidal silica having an average particle size of 50 nm (Particle No. 4).

Polishing Compositions 5G and 5H contained 0.1 wt.% glycine as a corrosion inhibitor, 0.005 wt.% ferric nitrate, 0.108 wt.% malonic acid as a stabilizer, and 15 ppm KATHON^{™} biocide.
Total defects on a substrate polished with the inventive polishing composition can be determined by any suitable technique. For example, laser light scattering techniques, such as dark field normal beam composite (DCN) and dark field oblique beam composite (DCO), can be used to determine particle defects on polished substrates. Suitable instrumentation for evaluating particle defectivity includes SURFSCAN^{™} SP2 instruments operating at a 110 nm threshold (available from KLA-Tencor).

The polishing results are set forth in Table 6.

**TABLE 6: Polishing Pad Defects as a Function of Type and Amount of Abrasive**

| **Polishing Compositions** | **SiO₂ Particle (wt.%)** | **Al₂O₃ Particle (wt.%)** | **Total Defects (Soft Pad)** | **Total Defects (Med.-Hard Pad)** |
|---|---|---|---|---|
| 5A | -- | 1 (0.5) | 147 | 236 |
| 5B | 6 (0.5) | 1 (0.2) | 52 | 69 |
| 5C | 6 (0.5) | 1 (0.5) | 48 | 65 |
| 5D | 6 (1) | 1 (0.2) | 54 | 69 |
| 5E | 6 (1) | 1 (0.5) | 75 | 57 |
| 5F | 10 (0.5) | 1 (0.5) | 48 | 92 |
| 5G | 6 (1) | -- | 53 | 69 |
| 5H | 4 (1) | -- | 45 | 113 |

As is apparent from the results set forth in Table 6, mixed particle polishing compositions exhibit lower defect counts as compared to a control composition comprising only surface-coated alumina particle. In addition, inventive Polishing Compositions 5B-5F exhibited suitable polishing performance on both medium hard and soft polishing pads.

### EXAMPLE 6

This example demonstrates the effect of relative amounts of silica particles and surface-coated alumina particles on topography performance for polishing compositions in accordance with the invention.

Substrates comprising tungsten-overcoated patterned silicon oxide-coated wafers having 3x1 µm features and 1x1 µm features were polished with five polishing compositions (i.e., Polishing Compositions 6A-6E), each having a pH of 3. First, the wafers were polished using a MIRRA^{™} tool with a M2000 pad (manufactured by Cabot Microelectronics Corp.) at 2.5 psi of downforce and a slurry flow rate of 150 mL/min. The patterned wafers were polished to 10% over-polish after the tungsten overburden was cleared. Next, the patterned wafers were buff polished with same pattern oxide loss with about 200 Å using a Fujibo H7000 Pad.

Polishing Compositions 6A, 6D, and 6E were control compositions. Polishing Composition 6A contained 0.5 wt.% of (AA-AMPS) copolymer coated α-alumina having an average particle size of 90 nm as the only abrasive particle (Particle No. 1). Polishing Composition 6D contained 1 wt.% of colloidal silica having an average particle size of 120 nm as the only abrasive particle (Particle No. 6). Polishing Composition 6E contained 1 wt.% of colloidal silica having an average particle size of 50 nm as the only abrasive particle (Particle No. 4).

Polishing Compositions 6B and 6C were inventive and each comprised 0.5 wt.% of (AA-AMPS) copolymer coated α-alumina having an average particle size of 90 nm (Particle No. 1). Polishing Composition 6B further comprised 0.5 wt.% of colloidal silica having an average particle size of 120 nm (Particle No. 6), and Polishing Composition 6C further comprised 1 wt.% of colloidal silica having an average particle size of 120 nm (Particle No. 6).

The polishing compositions and polishing results are set forth in Tables 7a and 7b.

**TABLE 7a: Topography as a Function of Type and Amount of Abrasive**

| **Polishing Composition** | **SiO₂ Particle (wt.%)** | **Al₂O₃ Particle (wt.%)** |
|---|---|---|
| 6A | -- | 1 (0.5) |
| 6B | 6 (0.5) | 1 (0.5) |
| 6C | 6 (1) | 1 (0.5) |
| 6D | 6 (1) | -- |
| 6E | 4 (1) | -- |

**TABLE 7b: Topography as a Function of Type and Amount of Abrasive**

| **Polishing Composition** | **Total Erosion Correction (Å) 3x1µm¹** | **Total Erosion Correction (Å) 1x1µm¹ (Å)** | **Δ Erosion Correction (Å)² (WIDNU)** | **W Roughness (Rₘₐₓ) (nm)³** |
|---|---|---|---|---|
| 6A | 82 | 12 | 70 | 9.9 |
| 6B | 34 | 27 | 7 | 10.3 |
| 6C | -11 | -16 | 5 | 10.3 |
| 6D | 85 | -43 | 128 | 29.2 |
| 6E | -66 | -206 | 140 | 15.9 |

| | | | | |
|---|---|---|---|---|
| ¹the total erosion was measured before and after buff polishing, wherein the difference was termed "total erosion correction" ²Δ erosion correction=total erosion correction of 3x1 µm feature-1x1 µm and this value was used to represent Within Die Non-Uniformity (WIDNU) in this invention ³W roughness is measured on 50 x 50 µm feature (Veeco) | | | | |

As is apparent by the results set forth in Table 7, specific silica abrasives mixed with treated alumina abrasive can improve Within Die Non-Uniformity (WIDNU), that is, non-uniform material removal on the areas with different pattern densities. Moreover, polishing compositions containing a mixed abrasive do not lead to worsening roughness performance.

The roughness of tungsten film polished by the inventive polishing compositions containing mixed abrasive slurries is comparable to the roughness of tungsten film polished by treated alumina abrasive slurry, and is much better than the roughness polished by silica-only based slurries.

Polishing Compositions 6B and 6C containing 0.5 wt.% of (AA-AMPS) copolymer coated α-alumina having an average particle size of 90 nm and 0.5 wt.% of colloidal silica having an average particle size of 120 nm (Polishing Composition 6B) or 1 wt.% of colloidal silica having an average particle size of 120 nm (Polishing Composition 6C) exhibited dramatically lower WIDNU (i.e., the lowest Delta erosion correction).

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description..

## Claims

1. A chemical-mechanical polishing composition comprising:
(a) an abrasive comprising negatively charged colloidal silica particles and alumina particles, wherein the alumina particles are surface-coated with an anionic polymer, wherein the polishing composition has a pH of about 2 to about 5, and
(b) water.

2. The polishing composition of claim 1, wherein the silica particles comprise colloidal silica particles, aluminum-doped silica particles, sulfonate modified colloidal silica or a combination thereof.

3. The polishing composition of claim 1, wherein the anionic polymer comprises repeating monomeric units selected from carboxylic acid monomeric units, sulfonic acid monomeric units, phosphonic acid monomeric units, and combinations thereof, wherein optionally the anionic polymer comprises repeating monomeric units selected from acrylic acid, methacrylic acid, itaconic acid, maleic acid, succinic acid, terephthalic acid, aspartic acid, maleic anhydride, 4-vinylbenzenesulfonic acid, vinyl sulfonic acid, 2-sulfoethyl acrylate, 2-sulfoethyl methacrylate, 3-sulfopropyl acrylate, 3-sulfopropyl methacrylate, 2-propene-1-sulfonic acid, styrene sulfonic acid, 2-acrylamido-2-methyl-1-propane sulfonic acid, vinylidene-1,1-diphosphonic acid, dimethyl-*p*-vinylbenzylphosphonate, ammonium bisdiethylphosphonate (meth)acrylate, acrylamide phosphonate monomers, vinylphosphonic acid, 2-(methacroyloxy)ethylphosphate, and combinations thereof.

4. The polishing composition of claim 1, wherein the anionic polymer comprises a copolymer comprising a combination of sulfonic acid monomeric units and carboxylic acid monomeric units, or a copolymer comprising a combination of sulfonic acid monomeric units and phosphonic acid monomeric units, wherein optionally the anionic polymer consists of 2-acrylamido-2-methylpropane sulfonic acid monomeric units and acrylic acid monomeric units.

5. The polishing composition of claim 1, wherein the anionic polymer consists of 2-acrylamido-2-methylpropane sulfonic acid monomeric units.

6. The polishing composition of claim 1, wherein the polishing composition further comprises an oxidizing agent.

7. The polishing composition of claim 6, wherein the oxidizing agent comprises ferric ion, wherein optionally the oxidizing agent further comprises hydrogen peroxide.

8. The polishing composition of claim 1, wherein the polishing composition further comprises a corrosion inhibitor.

9. The polishing composition of claim 8, wherein the corrosion inhibitor is glycine, lysine, arginine, alanine, or combinations thereof, wherein optionally the corrosion inhibitor is glycine.

10. The polishing composition of claim 1, wherein the polishing composition further comprises a stabilizer.

11. The polishing composition of claim 10, wherein the stabilizer is selected from acetic acid, phthalic acid, citric acid, adipic acid, oxalic acid, malonic acid, aspartic acid, succinic acid, glutaric acid, pimelic acid, suberic acid, azelaic acid, sebacic acid, maleic acid, glutaconic acid, muconic acid, ethylenediaminetetraacetic acid (EDTA), propylenediaminetetraacetic acid (PDTA), and combinations thereof, wherein optionally the stabilizer is malonic acid.

12. The polishing composition of claim 1, wherein the polishing composition further comprises an organic phosphonic acid, wherein optionally the organic phosphonic acid is selected from 2-aminoethylphosphonic acid, 1-hydroxyethylidene-1,1-diphosphonic acid, aminotri(methylenephosphonic acid), ethylenediaminetetra(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, α-methyl phosphonosuccinic acid, and combinations thereof.

13. The polishing composition of claim 1, wherein one or more of the following applies:
(i) the polishing composition has a pH of about 3 to about 3.5; and
(ii) the polishing composition further comprises an additive selected from a biocide, a buffer, a surfactant, a catalyst, a stabilizer, a corrosion inhibitor, and combinations thereof.

14. A method of chemically mechanically polishing a substrate comprising:
(i) providing a substrate,
(ii) providing a polishing pad,
(iii) providing a chemical-mechanical polishing composition according to any one of claims 1 to 13,
(iv) contacting the substrate with the polishing pad and the chemical-mechanical polishing composition, and
(v) moving the polishing pad and the chemical mechanical polishing composition relative to the substrate to abrade at least a portion of the substrate to polish the substrate.

15. The method of claim 14, wherein one or more of the following applies:
(i) the polishing composition further comprises an oxidizing agent, a corrosion inhibitor, a stabilizer, an organic phosphonic acid, or any combination thereof;
(ii) the substrate comprises a silicon oxide layer on a surface of the substrate, wherein at least a portion of the silicon oxide layer is abraded to polish the substrate; and
(iii) the substrate comprises a nitride layer on a surface of the substrate, wherein at least a portion of the nitride layer is abraded to polish the substrate.

## Patentansprüche

1. Zusammensetzung zum chemisch-mechanischen Polieren, umfassend:
(a) ein Schleifmittel, das negativ geladene kolloidale Siliciumdioxidpartikel und Aluminiumoxidpartikel umfasst, wobei die Aluminiumoxidpartikel mit einem anionischen Polymer oberflächenbeschichtet sind, wobei die Polierzusammensetzung einen pH-Wert von etwa 2 bis etwa 5 aufweist, und
(b) Wasser.

2. Polierzusammensetzung nach Anspruch 1, wobei die Siliciumdioxidpartikel kolloidale Siliciumdioxidpartikel, aluminiumdotierte Siliciumdioxidpartikel, sulfonatmodifiziertes kolloidales Siliciumdioxid oder eine Kombination davon umfassen.

3. Polierzusammensetzung nach Anspruch 1, wobei das anionische Polymer sich wiederholende Monomereinheiten umfasst, die aus Carbonsäure-Monomereinheiten, Sulfonsäure-Monomereinheiten, Phosphonsäure-Monomereinheiten und Kombinationen davon ausgewählt sind, wobei das anionische Polymer gegebenenfalls sich wiederholende Monomereinheiten umfasst, die aus Acrylsäure, Methacrylsäure, Itaconsäure, Maleinsäure, Bernsteinsäure, Terephthalsäure, Asparaginsäure, Maleinsäureanhydrid, 4-Vinylbenzolsulfonsäure, Vinylsulfonsäure, 2-Sulfoethylacrylat, 2-Sulfoethylmethacrylat, 3-Sulfopropylacrylat, 3-Sulfopropylmethacrylat, 2-Propen-1-sulfonsäure, Styrolsulfonsäure, 2-Acrylamido-2-methyl-1-propansulfonsäure, Vinyliden-1,1-diphosphonsäure, Dimethyl-p-vinylbenzylphosphonat, Ammoniumbisdiethylphosphonat (meth)acrylat, Acrylamidphosphonat-Monomeren, Vinylphosphonsäure, 2-(Methacroyloxy)ethylphosphat und Kombinationen davon ausgewählt sind.

4. Polierzusammensetzung nach Anspruch 1, wobei das anionische Polymer ein Copolymer, das eine Kombination von Sulfonsäure-Monomereinheiten und Carbonsäure-Monomereinheiten umfasst, oder ein Copolymer, das eine Kombination von Sulfonsäure-Monomereinheiten und Phosphonsäure-Monomereinheiten umfasst, umfasst, wobei das anionische Polymer gegebenenfalls aus 2-Acrylamido-2-methylpropansulfonsäure-Monomereinheiten und Acrylsäure-Monomereinheiten besteht.

5. Polierzusammensetzung nach Anspruch 1, wobei das anionische Polymer aus 2-Acrylamido-2-methylpropansulfonsäure-Monomereinheiten besteht.

6. Polierzusammensetzung nach Anspruch 1, wobei die Polierzusammensetzung ferner ein Oxidationsmittel umfasst.

7. Polierzusammensetzung nach Anspruch 6, wobei das Oxidationsmittel Eisen(III)-Ionen umfasst, wobei das Oxidationsmittel gegebenenfalls ferner Wasserstoffperoxid umfasst.

8. Polierzusammensetzung nach Anspruch 1, wobei die Polierzusammensetzung ferner einen Korrosionsinhibitor umfasst.

9. Polierzusammensetzung nach Anspruch 8, wobei es sich bei dem Korrosionsinhibitor um Glycin, Lysin, Arginin, Alanin oder Kombinationen davon handelt, wobei es sich bei dem Korrosionsinhibitor gegebenenfalls um Glycin handelt.

10. Polierzusammensetzung nach Anspruch 1, wobei die Polierzusammensetzung ferner einen Stabilisator umfasst.

11. Polierzusammensetzung nach Anspruch 10, wobei der Stabilisator aus Essigsäure, Phthalsäure, Citronensäure, Adipinsäure, Oxalsäure, Malonsäure, Asparaginsäure, Bernsteinsäure, Glutarsäure, Pimelinsäure, Korksäure, Azelainsäure, Sebacinsäure, Maleinsäure, Glutaconsäure, Muconsäure, Ethylendiamintetraessigsäure (EDTA), Propylendiamintetraaessigsäure (PDTA) und Kombinationen davon ausgewählt ist, wobei es sich bei dem Stabilisator gegebenenfalls um Malonsäure handelt.

12. Polierzusammensetzung nach Anspruch 1, wobei die Polierzusammensetzung ferner eine organische Phosphonsäure umfasst, wobei die organische Phosphonsäure gegebenenfalls aus 2-Aminoethylphosphonsäure, 1-Hydroxyethyliden-1,1-diphosphonsäure, Aminotri(methylenphosphonsäure), Ethylendiamintetra(methylenphosphonsäure), Diethylentriaminpenta(methylenphosphonsäure), Ethan-1,1-diphosphonsäure, Ethan-1,1,2-triphosphonsäure, Ethan-1-hydroxy-1,1-diphosphonsäure, Ethan-1-hydroxy-1,1,2-triphosphonsäure, Ethan-1,2-dicarboxy-1,2-diphosphonsäure, Methanhydroxyphosphonsäure, 2-Phosphonobutan-1,2-dicarbonsäure, 1-Phosphonobutan-2,3,4-tricarbonsäure, α-Methylphosphonobernsteinsäure und Kombinationen davon ausgewählt ist.

13. Polierzusammensetzung nach Anspruch 1, wobei eine oder mehrere der folgenden Aussagen zutrifft/zutreffen:
(i) die Polierzusammensetzung weist einen pH-Wert von etwa 3 bis etwa 3,5 auf und
(ii) die Polierzusammensetzung umfasst ferner ein Additiv, das aus einem Biozid, einem Puffer, einem Tensid, einem Katalysator, einem Stabilisator, einem Korrosionsinhibitor und Kombinationen davon ausgewählt ist.

14. Verfahren zum chemisch-mechanischen Polieren eines Substrats, umfassend:
(i) Bereitstellen eines Substrats,
(ii) Bereitstellen eines Polierkissens,
(iii) Bereitstellen einer Zusammensetzung zum chemisch-mechanischen Polieren nach einem der Ansprüche 1 bis 13,
(iv) Inkontaktbringen des Substrats mit dem Polierkissen und der Zusammensetzung zum chemisch-mechanischen Polieren und
(v) Bewegen des Polierkissens und der Zusammensetzung zum chemisch-mechanischen Polieren relativ zum Substrat zum Abtragen mindestens eines Teils des Substrats zum Polieren des Substrats.

15. Verfahren nach Anspruch 14, wobei eine oder mehrere der folgenden Aussagen zutrifft/zutreffen:
(i) die Polierzusammensetzung umfasst ferner ein Oxidationsmittel, einen Korrosionsinhibitor, einen Stabilisator, eine organische Phosphonsäure oder eine beliebige Kombination davon;
(ii) das Substrat umfasst eine Siliciumoxidschicht auf einer Oberfläche des Substrats, wobei mindestens ein Teil der Siliciumoxidschicht zum Polieren des Substrats abgetragen wird; und
(iii) das Substrat umfasst eine Nitridschicht auf einer Oberfläche des Substrats, wobei mindestens ein Teil der Nitridschicht zum Polieren des Substrats abgetragen wird.

## Revendications

1. Composition de polissage mécano-chimique comprenant :
(a) un abrasif comprenant des particules de silice colloïdale chargées négativement et des particules d'alumine chargées négativement, dans laquelle les particules d'alumine sont revêtues en surface par un polymère anionique, dans laquelle la composition de polissage a un pH d'environ 2 à environ 5, et
(b) de l'eau.

2. Composition de polissage selon la revendication 1, dans laquelle les particules de silice comprennent des particules de silice colloïdale, des particules de silice dopée à l'aluminium, une silice colloïdale modifiée par un sulfonate ou une combinaison de celles-ci.

3. Composition de polissage selon la revendication 1, dans laquelle le polymère anionique comprend des motifs monomériques répétitifs choisis parmi des motifs monomériques d'acide carboxylique, des motifs monomériques d'acide sulfonique, des motifs monomériques d'acide phosphonique, et leurs combinaisons, dans laquelle éventuellement le polymère anionique comprend des motifs monomériques répétitifs choisis parmi l'acide acrylique, l'acide méthacrylique, l'acide itaconique, l'acide maléique, l'acide succinique, l'acide téréphtalique, l'acide aspartique, l'anhydride maléique, l'acide 4-vinylbenzènesulfonique, l'acide vinylsulfonique, l'acrylate de 2-sulfoéthyle, le méthacrylate de 2-sulfoéthyle, l'acrylate de 3-sulfopropyle, le méthacrylate de 3-sulfopropyle, l'acide 2-propène-1-sulfonique, l'acide styrènesulfonique, l'acide 2-acrylamido-2-méthyl-1-propanesulfonique, l'acide vinylidène-1,1-diphosphonique, le diméthyl-p-vinylbenzylphosphonate, le bisdiéthylphosphonate d'ammonium (méth)acrylate, les monomères de phosphonate d'acrylamide, l'acide vinylphosphonique, le 2-(méthacroyloxy)éthylphosphate et leurs combinaisons.

4. Composition de polissage selon la revendication 1, dans laquelle le polymère anionique comprend un copolymère comprenant une combinaison de motifs monomériques d'acide sulfonique et de motifs monomériques d'acide carboxylique, ou un copolymère comprenant une combinaison de motifs monomériques d'acide sulfonique et de motifs monomériques d'acide phosphonique, dans laquelle éventuellement le polymère anionique est constitué de motifs monomériques d'acide 2-acrylamido-2-méthylpropanesulfonique et de motifs monomériques d'acide acrylique.

5. Composition de polissage selon la revendication 1, dans laquelle le polymère anionique est constitué de motifs monomériques d'acide 2-acrylamido-2-méthylpropanesulfonique.

6. Composition de polissage selon la revendication 1, dans laquelle la composition de polissage comprend en outre un agent oxydant.

7. Composition de polissage selon la revendication 6, dans laquelle l'agent oxydant comprend un ion ferrique, dans laquelle éventuellement l'agent oxydant comprend en outre du peroxyde d'hydrogène.

8. Composition de polissage selon la revendication 1, dans laquelle la composition de polissage comprend en outre un inhibiteur de corrosion.

9. Composition de polissage selon la revendication 8, dans laquelle l'inhibiteur de corrosion est la glycine, la lysine, l'arginine, l'alanine, ou leurs combinaisons, dans laquelle éventuellement l'inhibiteur de corrosion est la glycine.

10. Composition de polissage selon la revendication 1, dans laquelle la composition de polissage comprend en outre un stabilisant.

11. Composition de polissage selon la revendication 10, dans laquelle le stabilisant est choisi parmi l'acide acétique, l'acide phtalique, l'acide citrique, l'acide adipique, l'acide oxalique, l'acide malonique, l'acide aspartique, l'acide succinique, l'acide glutarique, l'acide pimélique, l'acide subérique, l'acide azélaïque, l'acide sébacique, l'acide maléique, l'acide glutaconique, l'acide muconique, l'acide éthylènediaminetétraacétique (EDTA), l'acide propylènediaminetétraacétique (PDTA) et leurs combinaisons, dans laquelle le stabilisant est éventuellement l'acide malonique.

12. Composition de polissage selon la revendication 1, dans laquelle la composition de polissage comprend en outre un acide phosphonique organique, dans laquelle éventuellement l'acide phosphonique organique est choisi parmi l'acide 2-aminoéthylphosphonique, l'acide 1-hydroxyéthylidène-1,1-diphosphonique, l'acide aminotri(méthylènephosphonique), l'acide éthylènediaminetétra(méthylènephosphonique), l'acide diéthylènetriaminepenta(méthylènephosphonique), l'acide éthane-1,1-diphosphonique, l'acide éthane-1,1,2-triphosphonique, l'acide éthane-1-hydroxy-1,1-diphosphonique, l'acide éthane-1-hydroxy-1,1,2-triphosphonique, l'acide éthane-1,2-dicarboxy-1,2-diphosphonique, l'acide méthanehydroxyphosphonique, l'acide 2-phosphonobutane-1,2-dicarboxylique, l'acide 1-phosphonobutane-2,3,4-tricarboxylique, l'acide α-méthylphosphonosuccinique et leurs combinaisons.

13. Composition de polissage selon la revendication 1, dans laquelle un ou plusieurs des énoncés suivants s'appliquent :
(i) la composition de polissage a un pH d'environ 3 à environ 3,5 ; et
(ii) la composition de polissage comprend en outre un additif choisi parmi un biocide, un tampon, un tensioactif, un catalyseur, un stabilisant, un inhibiteur de corrosion et leurs combinaisons.

14. Procédé de polissage mécano-chimique d'un substrat comprenant :
(i) la fourniture d'un substrat,
(ii) la fourniture d'un tampon de polissage,
(iii) la fourniture d'une composition de polissage mécano-chimique selon l'une quelconque des revendications 1 à 13,
(iv) la mise en contact du substrat avec le tampon de polissage et la composition de polissage mécano-chimique, et
(v) le déplacement du tampon de polissage et de la composition de polissage mécano-chimique par rapport au substrat pour abraser au moins une partie du substrat afin de polir le substrat.

15. Procédé selon la revendication 14, dans lequel l'un ou plusieurs des énoncés suivants s'appliquent :
(i) la composition de polissage comprend en outre un agent oxydant, un inhibiteur de corrosion, un stabilisant, un acide phosphonique organique, ou une quelconque combinaison de ceux-ci ;
(ii) le substrat comprend une couche d'oxyde de silicium sur une surface du substrat, au moins une partie de la couche d'oxyde de silicium étant abrasée pour polir le substrat ; et
(iii) le substrat comprend une couche de nitrure sur une surface du substrat, au moins une partie de la couche de nitrure étant abrasée pour polir le substrat.
